# EUROPEAN PATENT APPLICATION

(11) **EP 2 461 449 A1**
(43) Date of publication of application: **06.06.2012**
(21) Application number: 11190812.5
(22) Date of filing: 25.11.2011
(51) Int. Cl.: H02H 1/00, B64D 45/00, H01H 9/50, G01R 31/12

(54) **Arc fault detection method and system**

(30) Priority: 08.04.2011 US 82470; 02.12.2010 US 418998 P
(71) Applicant: Hamilton Sundstrand Corporation, Windsor Locks, CT 06096-1010 (US)
(72) Inventor: Gillis, Thomas M., Rockford, IL Illinois 61103 (US); Fillmore, Robert L., Bloomington, MN Minnesota 55437 (US); Hubbard, William Boyd, Winnebago, IL Illinois 61088 (US); Wetzel, Richard T., Davis Junction, IL Illinois 61020 (US); Norris, Robert J., Wilson, NC North Carolina 27896 (US)
(74) Representative: Leckey, David Herbert

(57) **Abstract**

An example arc fault detection system (10) includes an electrical system (26), an electrical controller (14), a sensor (18,34a,34b,34c), and a master controller (22). The electrical controller (14) detects a voltage of the electrical system (26), a current of the electrical system (26), or both. The sensor (18,34a,34b,34c) detects an ultraviolet light level of the electrical system (26). The master controller (22) is configured to communicate with the electrical controller (14) and the sensor (18,34a,34b,34c). The master controller (22) isolates the electrical system (26) in response to receiving a signal from the electrical controller (14) and the sensor (18,34a,34b,34c). An example method (200) of isolating an arc fault in an electrical system includes detecting a voltage level (216), a current level (224), and an ultraviolet light level (204) of the electrical system (26). The method isolates an arc fault (232) based on the voltage level or the current level, and the ultraviolet light level from the detecting.

## Description

### BACKGROUND

This disclosure relates generally to arc fault detection and, more particularly, to combined ultraviolet and electrical characteristic-based arc fault detection.

Recent trends in aircraft electrical system design have included increasing total electrical demand and component consolidations to reduce weight and eliminate wiring. Removing wires and consolidating components achieves significant weight savings, but also increases the risk of possible equipment and aircraft damage from electrical arc faults because of higher generator line voltages and higher component power densities. Arc faults can introduce very high temperatures into the aircraft. Other undesirable characteristics of arc faults include the potential for molten metal near the arc fault, shrapnel, and intense light. Quickly isolating the arc fault can lessen the severity of these characteristics. Isolating the arc fault includes removing the electric power source from the arc fault and a bus tie contactor lockout to prevent backup sources from also being affected by a single fault.

Detecting a bus arc fault quickly and reliably is necessary to effectively isolate the arc fault and prevent damage. Arcs give off significant UV light and energy having a relatively small wavelength that is outside the visible and infrared light spectrums. Some systems detect UV light to identify an arc fault. Such systems may experience false alarms from sources, such as solar radiation, manmade UV light, normal corona from a contactor switching at altitude, etc.

### SUMMARY

An example arc fault detection system includes an electrical system, an electrical controller, a sensor, and a master controller. The electrical controller detects a voltage of the electrical system, a current of the electrical system, or both. The sensor detects an ultraviolet light level of the electrical system. The master controller is configured to communicate with the electrical controller and the sensor. The master controller isolates the electrical system in response to receiving a signal from the electrical controller and the sensor.

An example aircraft arc fault detection system includes an aircraft electrical subsystem, an electrical controller arrangement, and an ultraviolet sensor arrangement. The electrical controller arrangement detects a voltage and a current of the aircraft electrical subsystem. The ultraviolet sensor arrangement detects an ultraviolet light level of the aircraft electrical subsystem. A master controller communicates with the aircraft electrical subsystem, the electrical controller arrangement, and the ultraviolet sensor arrangement. The master controller isolates the aircraft electrical subsystem in response to a voltage droop, a rise in phase current, and an ultraviolet light level.

An example method of isolating an arc fault in an electrical system includes detecting a voltage level, a current level, and an ultraviolet light level of the electrical system. The method isolates an arc fault based on the voltage level or the current level, and the ultraviolet light level from the detecting.

These and other features of the disclosed examples can be best understood from the following specification and drawings, the following of which is a brief description.

### BRIEF DESCRIPTION OF THE FIGURES

Figure 1 shows a highly schematic view example arc fault detection system.
Figure 2 shows a partially schematic and perspective view of the Figure 1 arc fault detection system.
Figure 3 shows a perspective view of an ultraviolet sensor used in the Figure 1 system.
Figure 4 shows a close-up view of the Figure 3 sensor mounted within the Figure 1 system.
Figure 5 shows another example ultraviolet sensor having an internal wiring arrangement.
Figure 6 shows an example electrical power system for an aircraft that includes the detection system of Figure 1.
Figure 7 shows the flow of an example method for detecting arc faults within the Figure 1 system.

### DETAILED DESCRIPTION

An example arc fault detection system 10 includes an electrical controller 14, an ultraviolet sensor arrangement 18, and a master controller 22. The electrical controller 14 is configured to monitor electrical characteristics of a power distribution panel 26. The ultraviolet sensor arrangement 18 is configured to detect ultraviolet light within or near the power distribution panel 26. The master controller 22 utilizes the electrical characteristics from the electrical controller 14 and the ultraviolet light characteristics from the ultraviolet sensor arrangement 18 to determine whether an arc fault has occurred. If so, the master controller 22 isolates the power distribution panel 26.

In this example, the power distribution panel 26 forms a portion of an electrical power system for an aircraft. Other types of aircraft electrical power systems or subsystem include main power generators, bus power control boxes, secondary power distribution boxes, DC-based equipment, auxiliary power unit gas turbine driven power sources, and emergency power systems. Although the arc fault detection system 10 is described as used with the power distribution panel 26, other examples may include utilizing the arc fault detection system 10 with any of the aircraft electrical power systems described above, or other power systems or subsystems that are not associated with an aircraft.

The example electrical controller 14 monitors the power conditions of the power distribution panel 26. The master controller 22 determines variants of the power conditions within the power distribution panel 26 from a steady state power conditions. In one example, a normal line voltage for the power distribution panel 26 is 235V and a normal current for the power distribution panel 26 is 300 amps per phase. The master controller 22 is configured to detect variations from these norms. For example, the master controller 22 may identify a voltage droop and a rise in phase currents, which are characteristics of an arc fault. In some examples, the arc fault voltage and current detection thresholds for a given application are determined empirically (via testing) and will vary from system to system based on generator power rating, feeder impedances, and the impedance of bus faults induced. As a typical example, a 235Vac system with high current capacity was tested and determined to operate reliably using 110V drop and 100Amp current spike as detection thresholds.

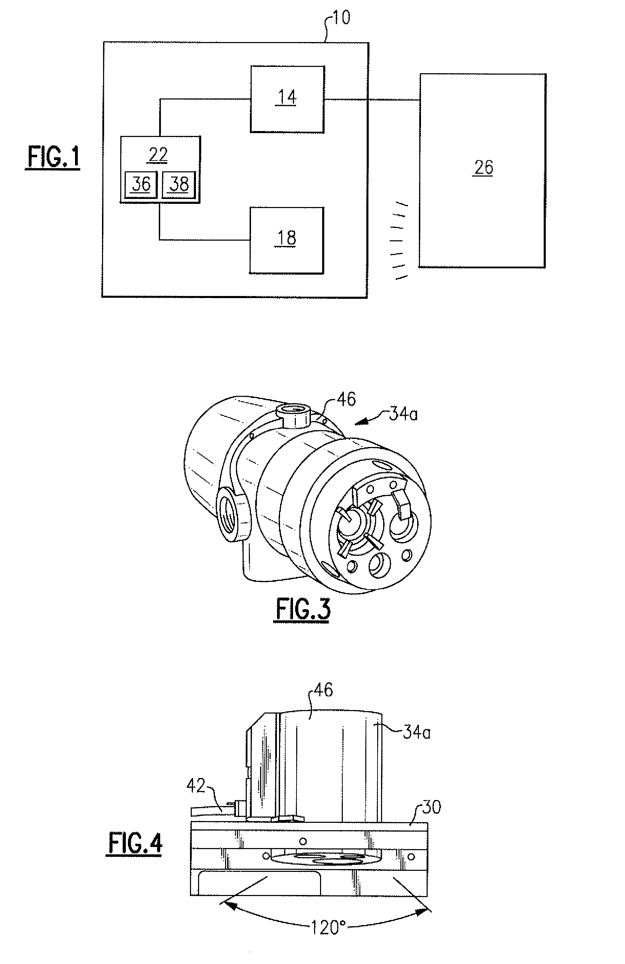

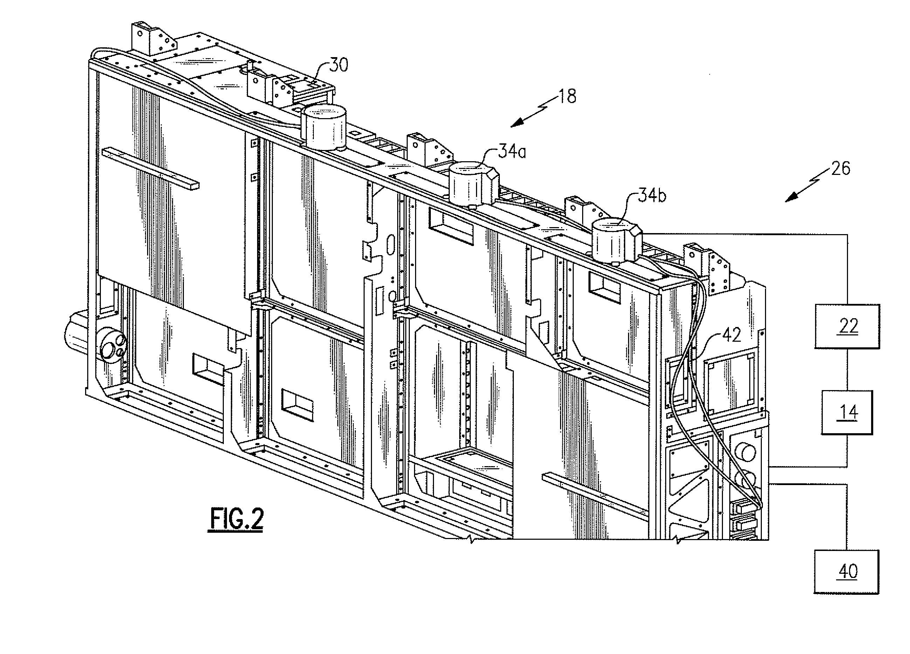

Referring to Figure 2 with continuing reference to Figure 1, the example power distribution panel 26 includes a housing 30. The ultraviolet sensor arrangement 18 includes a plurality of sensors 34a-34b mounted directly to the housing 30. The plurality of sensors 34a-34b are distributed circumferentially about the housing 30 and are configured to detect ultraviolet light within, or reflected from, the power distribution panel 26.

The example power distribution panel 26 distributes power from a main power supply 40 to other areas of the aircraft. In this example, the sensors 34a-34b are powered by the power distribution panel 26, the power supply 40, or both. Power supply wires 42 are used to communicate power to the sensors 34a-34b. The power supply wires 42 are external to the housing 30 in this example.

The master controller 22 receives information from the electrical controller 14 and the ultraviolet sensors 34a-34b. The master controller 22 uses the information to determine whether the power distribution panel 26 has experienced an arc fault and whether the power distribution panel 26 should be isolated from other power systems within the aircraft.

In this example, the master controller 22 isolates the power distribution panel 26 if the master controller 22 detects a combination of a voltage droop, a rise in phase currents, and an indication of a sufficient level of ultraviolet light. Such a combination of variables indicates the presence of an arc fault within the power distribution panel 26. That is, when a sufficient level of ultraviolet light is detected and coincident with voltage droop and rising phase currents, the master controller 22 deexcites the associated generator source and locks out bus transfers from the associated power distribution panel. The specific response to the detection may vary in other examples. Voltage levels, current levels, and ultraviolet light levels indicative of an arc fault may be adjustable within the master controller 22.

In this example, the ultraviolet light threshold levels may be adjustable within the master controller 22, the ultraviolet sensor arrangement 18, or may be predetermined and set in the ultraviolet sensor arrangement 18 to alert the master controller 22 when there is ultraviolet light above normal levels per the installation.

The master controller 22 may include a processor 36 for executing software, particularly software designed to isolate the power distribution panel 26 in response to a combination of a voltage droop, a rise in phase currents, and detected ultraviolet light. The processor 36 can be a custom made or commercially available processor, a central processing unit, an auxiliary processor among several processors, a semiconductor based microprocessor (in the form of a microchip or chip set), or generally any device for executing software instructions.

The processor 36 can be configured to execute software stored within a memory portion 38 of the master controller 22, to communicate data to and from the memory portion 38, and to generally control operations of the master controller 22 pursuant to the software. Software in a memory portion of the master controller 22 is read by the processor 36, perhaps buffered within the processor 36, and then executed.

Referring now to Figures 3 and 4, the example ultraviolet sensor 34a includes a housing 46 suitable for a harsh industrial environment. The example ultraviolet sensor 34a is also substantially immune to solar radiation and load bus corona under normal operation. The ultraviolet sensor 34a, in this example, is configured to communicate information about the presence of ultraviolet light within 50 milliseconds of an arc fault. Notably, the ultraviolet sensor 34a is able to detect direct or reflected ultraviolet light and has a 120 degree field of view.

Regarding the power supplied to the ultraviolet sensor 34a through the power supply wires 42, the input voltage is typically between 18 and 32 Vdc. The operating temperature of the ultraviolet sensor 34a is typically between -40 and 75°C. The ultraviolet sensor 34a also weighs about 0.5 lbs. (0.227 kg) and is operatable at between 0% - 95% relative humidity.

The example ultraviolet sensor 34a is able to detect ultraviolet light from a variety of locations relative to the power distribution panel 26, such as from within the power distribution panel 26 or mounted externally to the power distribution panel 26 looking into cooling orifices. In another example, the ultraviolet sensor 34a is spaced from the power distribution panel 26, but oriented toward cooling orifices of the power distribution panel 26.

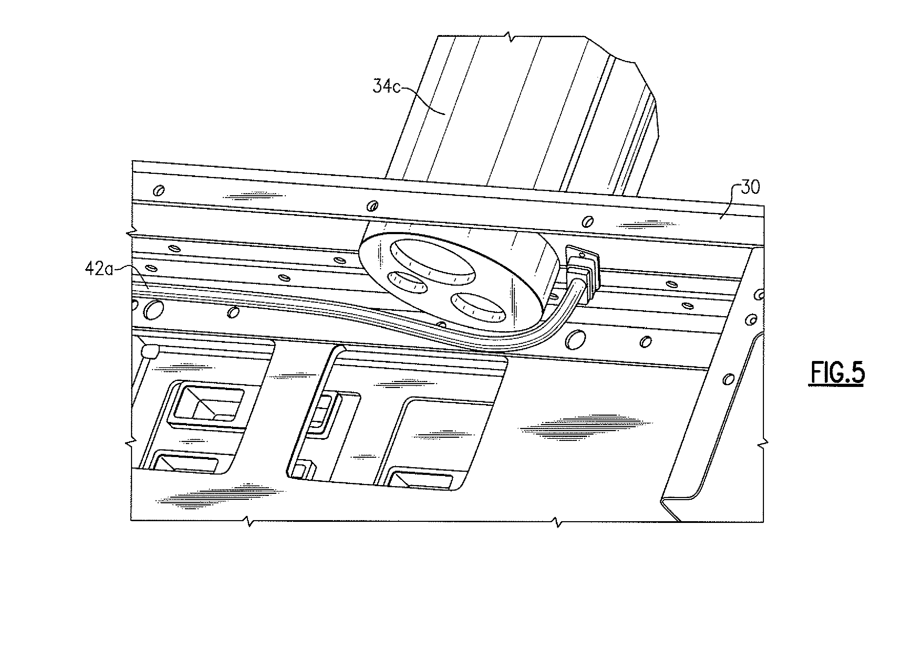

Referring to Figure 5, in another example, an ultraviolet sensor 34c is mounted to the housing 30 but is wired to receive power communicated through a wire 42a located within the housing 30.

Referring again to Figure 2, the example electrical controller 14 is a generator controller configured to regulate voltage output. The controller 14 may include a current sensing circuit and a transformer voltage detection circuit that enable current and voltage detection on a per phase basis.

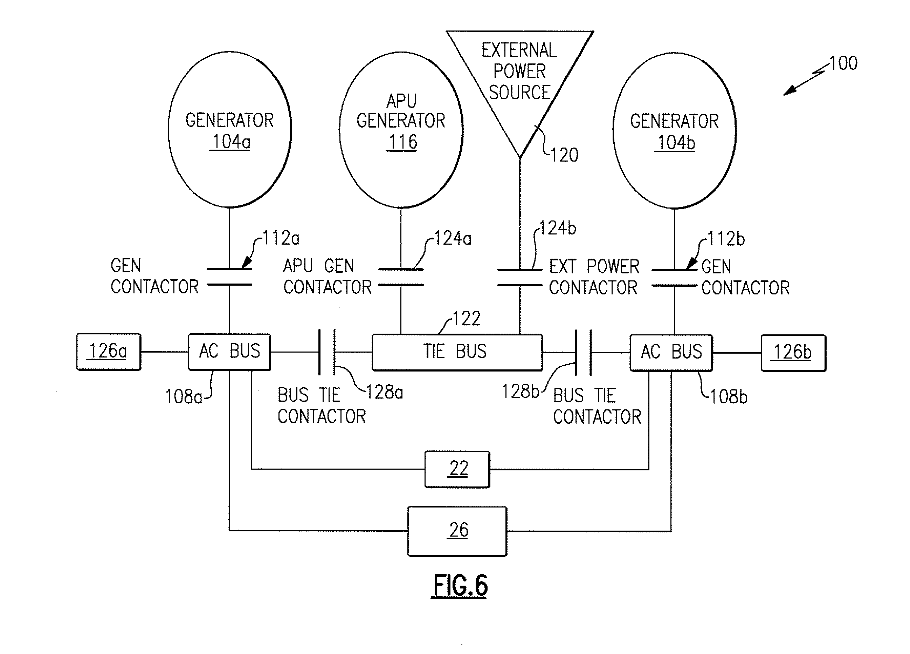

An example two-channel electrical power system 100 for an aircraft is depicted in Figure 6. In this example, the power distribution panel 26 (Figure 1) distributes power provided by the system 100. That is, the system 100 is an example of the main power system 40 (Figure 2).

The system 100 includes two engine gearbox driven generators 104a and 104b. Each generator powers a separate load bus 108a and 108b through a three-phase electromechanical contactor 112a and 112b. Backup power to the load buses 108a and 108b is provided by a gas turbine powered auxiliary power unit 116 or a three-phase external power connection 120 on the ground. The backup power sources 116 and 120 connect to a tie bus 122 through contactors 124a and 124b, respectively.

A control unit 126a and 126b is matched to each load bus 108a and 108b. The control units 126a and 126b provide basic line voltage regulation, generator protective functions (typically feeder ground fault, overvoltage, undervoltage, etc.), closed loop frequency control (if needed for constant frequency generators), communications, fault reporting/fault isolation and system status displays to a cockpit of the aircraft.

To provide adequate system reliability, the generators 104a and 104b are cross connected through respective bus tie contactors 128a and 128b. In the event of a generator failure, the system control logic allows for an available backup source (such as the unit 116 or the power connection 120) to power the failed generator by closing the appropriate bus tie contactor 128a or 128b. The master controller 22 of the system 10 (Figure 1) is configured to initiate the closing of the contactor 128a or 128b. If an AC load bus is shorted or has an arc fault, the master controller 22 of the example system 10 opens and locks out both the electromechanical contactor 112a or 112b and the associated bus tie contactor 124a or 124b, thus preventing the backup sources from cycling into the faulted bus 108a or 108b.

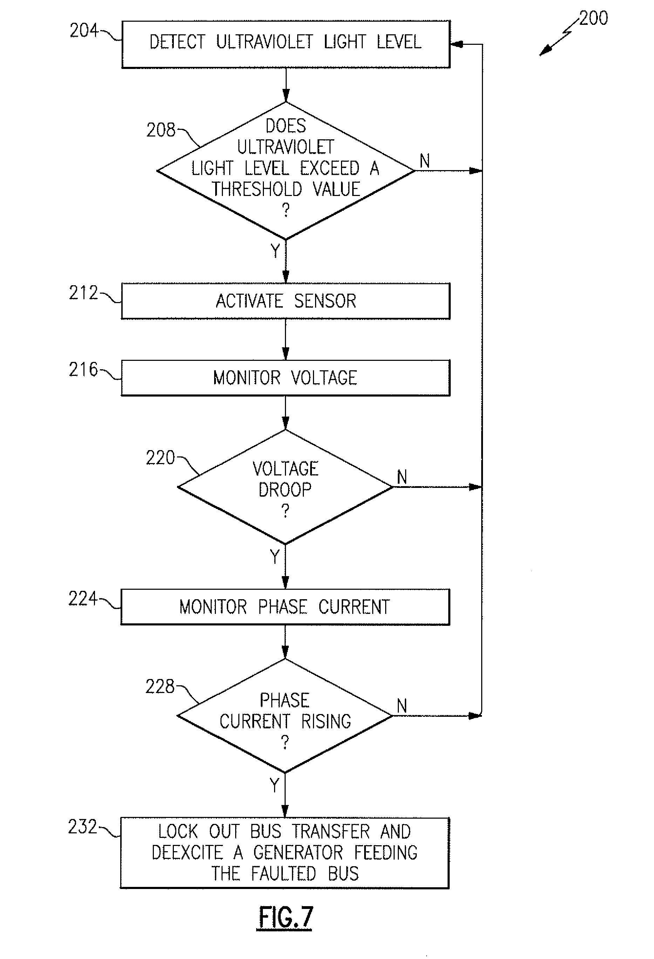

Referring to Figure 7, the flow of an example method 200 for detecting an arc fault within a power panel includes a step 204 of detecting an ultraviolet light level. The ultraviolet light level is compared to an ultraviolet threshold value, such as a detected level per unit time, at a step 208. If the ultraviolet light level exceeds the threshold value, an ultraviolet light level sensor is considered activated at a step 212. Voltage is monitored at a step 216. If a voltage droop is detected at a step 220, the method 200 monitors phase current at a step 224. If the phase current is rising at a step 220, bus transfers from the monitored panel are locked at a step 232.

The sequence of steps in method 200 is not limited to the order depicted in Figure 7. For example, detection of ultraviolet light level can be performed in parallel with monitoring of voltage and/or current. Additionally, when sensors perform steps 204-212, the master controller 22 (Figure 1) may not receive an indication of activation of one or more sensors 34a-34b until during or after execution of steps 216-228. However, step 232 is not performed until a combination of ultraviolet sensor activation is detected with one or more of a voltage droop and rising phase current.

Features of the disclosed examples have been shown to provide a detection probability for arc faults that is greater than .999 and a probability for false alarms that is less than .001. Another feature of the disclosed examples include a relatively fast acting method for responding to an arc fault that is less than 100 milliseconds from an arc fault start to isolation of the power source experiencing the arc fault. Yet another feature of the disclosed examples is a system that relies on a combination of software algorithm detecting voltage and current anomalies symptomatic of arc faults with a calibrated UV sensor to provide optimum system fault detection performance: 1) very high fault detection probability plus 2) high false alarm immunity.

The preceding description is exemplary rather than limiting in nature. Variations and modifications to the disclosed examples may become apparent to those skilled in the art that do not necessarily depart from the essence of this disclosure. Thus, the scope of legal protection given to this disclosure can only be determined by studying the following claims.

## Claims

1. An arc fault detection system (10), comprising:
an electrical system (26);
an electrical controller (14) configured to detect at least one of a voltage and a current of the electrical system (26);
a sensor (18,34a,34b,34c) configured to detect an ultraviolet light level of the electrical system (26); and
a master controller (22) configured to communicate with the electrical controller (14) and the sensor (18,34a,34b,34c), wherein the master controller (22) isolates the electrical system (26) in response to receiving a signal from each of the electrical controller (14) and the sensor (18,34a,34b,34c).

2. The arc fault detection system (10) of claim 1, wherein the electrical controller (14) comprises an electrical sensor.

3. The arc fault detection system (10) of claim 1 or 2, wherein the sensor (18,34a,34b,34c) is an ultraviolet sensor, optionally configured to detect a reflected ultraviolet light level, a direct ultraviolet light level, or both.

4. The arc fault detection system (10) of claim 3, wherein the ultraviolet sensor (18,34a,34b,34c) has a 120 degree field of view.

5. The arc fault detection system (10) of any preceding claim, wherein the master controller (22) is configured to identify a voltage droop based on information from the electrical controller (14).

6. The arc fault detection system (10) of any preceding claim, wherein the master controller (22) is configured to identify a rise in phase current based on information from the electrical controller (14).

7. An aircraft arc fault detection system, comprising:
an arc fault detection system as set forth in claim 1;
wherein said electrical system (26) is an aircraft electrical subsystem;
wherein said electrical controller (14) is configured to detect a voltage and a current of the aircraft electrical subsystem (26);
wherein said sensor (18,34a,34b,34c) is an ultraviolet sensor arrangement (18) configured to detect an ultraviolet light level of the aircraft electrical subsystem (26); and
wherein said master controller (22) is configured to communicate with the aircraft electrical subsystem (26), the electrical controller (14), and the ultraviolet sensor arrangement (18), wherein the master controller (22) isolates the aircraft electrical subsystem (26) in response to a voltage droop, a rise in phase current, and the ultraviolet light level.

8. The aircraft arc fault detection system of claim 7, wherein the aircraft electrical subsystem (26) comprises a housing (30), and the ultraviolet sensor arrangement (18) includes a plurality of individual sensors (34a,34b,34c) mounted directly to the housing (30), and optionally further including wiring (42) configured to communicate power to each of the plurality of individual sensors (34a,34b,34c), the wiring (42) disposed inside the housing (30).

9. The aircraft arc fault detection system of any of claims 7 or 8, including a bus tie contactor (128a,128b) that selectively couples a generator (116) of the aircraft electrical subsystem (26) to a load bus (108a,108b), wherein the master controller (22) is configured to decouple the bus tie contactor (128a,128b) to isolate the aircraft electrical subsystem (26).

10. A method (200) of isolating an arc fault in an electrical system, comprising:
detecting a voltage level (216), a current level (224), and an ultraviolet light level (204) of the electrical system; and
isolating an arc fault (232) based on the voltage level or the current level, and the ultraviolet light level from the detecting.

11. The method of claim 10, including isolating the arc fault (232) based on the voltage level, the current level, and the ultraviolet light level.

12. The method of claim 10, including isolating the arc fault (232) based on a voltage droop (220) and the ultraviolet light level.

13. The method of claim 10 or 12, including isolating the arc fault based on a rising phase current (228) and the ultraviolet light level.

14. The method of any of claims 10 to 13, wherein the electrical system comprises an aircraft power distribution panel.

15. The method of any of claims 10 to 14, wherein the isolating (232) includes opening and looking-out a contactor (112a,112b,124a,124b,128a,128b) of the electrical system, wherein optionally the contactor (112a,112b,124a,124b,128a,128b) comprises a first contactor (112a,112b) that selectively couples a generator (104a,104b) to an AC bus (108a,108b), a second contactor (128a,128b) that selectively couples the AC bus (108a,108b) to a tie bus (122), or both the first contactor (112a,112b) and the second contactor (128a,128b).
